Europäisches Patentamt

European Patent Office

Office européen des brevets

(19)

(11) Publication number : **0 509 633 B1**

## (12) EUROPEAN PATENT SPECIFICATION

(45) Date of publication of patent specification :
**18.01.95 Bulletin 95/03**

(51) Int. Cl.⁶ : **G06F 11/20, G11C 8/00, G11C 16/00, G11C 17/00**

(21) Application number : **92301917.8**

(22) Date of filing : **05.03.92**

(54) Semiconductor memory.

(30) Priority : **07.03.91 JP 42072/91**

(43) Date of publication of application :
**21.10.92 Bulletin 92/43**

(45) Publication of the grant of the patent :
**18.01.95 Bulletin 95/03**

(84) Designated Contracting States :
**DE FR GB**

(56) References cited :
**EP-A- 0 086 905**
**EP-A- 0 163 580**
**EP-A- 0 224 206**
**EP-A- 0 383 452**

(56) References cited :
**EP-A- 0 419 202**
**FR-A- 2 312 837**
**IBM TECHNICAL DISCLOSURE BULLETIN,**
**vol. 7, no.6, 6th Nov. 1964, pages 436-437**

(73) Proprietor : **SHARP KABUSHIKI KAISHA**
**22-22 Nagaike-cho**
**Abeno-ku**
**Osaka 545 (JP)**

(72) Inventor : **Hotta, Yasuhiro**
**4-372-3, Minamikyobate-cho**
**Nara-shi, Nara-ken (JP)**

(74) Representative : **Brown, Kenneth Richard et al**
**R.G.C. Jenkins & Co.**
**26 Caxton Street**
**London SW1H 0RJ (GB)**

EP 0 509 633 B1

## Description

## BACKGROUND OF THE INVENTION

1. Field of the Invention:

The present invention relates to a nonvolatile semiconductor memory in general, and to a nonvolatile semiconductor memory that is partially rewritable and inexpensive in construction in particular.

2. Description of the Prior Art:

Nonvolatile semiconductor memories are known in the art. Masked read-only memories (mask ROMs) have been used for applications that require low-cost large-volume production. For low volume-production or for applications that may subsequently require altering the stored data, programmable read-only memories (PROMs) have been the logical choice.

The mask ROM is a type of read-only memory in which data is written using a mask during fabrication of the memory. Therefore, the stored data cannot be altered by any means once the memory is fabricated, but the advantage is that the mask ROM can be manufactured economically by large-volume production. On the other hand, the PROM, though a nonvolatile memory, allows the stored data to be altered electrically under specified conditions. However, for large-volume production, the PROM is more expensive than the mask ROM of the comparable capacity. There are several types of PROM, among which the erasable PROM (EPROM) uses ultraviolet radiation for data erasure and the electrically erasable PROM (EEPROM) achieves data erasure by electrical means.

However, in the case of using mask ROMs in large-volume production, if any data error is discovered before the start of volume production, all the prepared chips have to be scrapped and the manufacture must be started over again from the mask design stage. Furthermore, with the increasing packing density and memory capacity of semiconductor memory in recent years, the risk involved in the manufacture of the memory also has been increasing. For example, all the large-capacity memory chips prepared for production would be rendered useless even if only a slight modification to the data should become necessary.

In addition, the demand for shortening the time for product development has been rising each year. Such demand makes it even more difficult to ensure the ROM data is free from error before the start of volume production. Thus, the possibility of having to rewrite data for correction is increased.

In view of the above, it will be appreciated that a particular problem with the conventional mask ROM is that a great deal of time and money is needed for corrective measures when errors are found in the stored data.

If PROMs of comparable memory size are used to avoid the above problem associated with ROMs, the major advantage of large-volume production will be lost. Furthermore, writing data to a PROM requires a great deal of time, and consequently productivity suffers greatly. This is particularly true in the case of EPROMs which are relatively cheap compared with EEPROMs. In the case of EPROMs, the entire chip must be rewritten even when only part of the data needs altering.

Therefore, there is a strong need in the art for a nonvolatile semiconductor memory which can be partially rewritten without having to rewrite the entire chip. There is a strong need in the art for such a nonvolatile memory which reduces the time and expense associated with taking corrective measures when using conventional nonvolatile semiconductor memories.

The document EP-A-0 383 452 discloses a semiconductor memory device having the pre-characterising features of claim 1. IBM Technical Disclosure Bulletin vol. 7 no. 6, November 1964, pages 436-437 and FR-A- 2 312 837 disclose devices having a main memory and a programmable secondary memory for storing data to replace data stored in the main memory.

The present invention aims to overcome the aforementioned and other short comings of the above known nonvolatile semiconductor memories. The present invention is summarized and described in detail below.

## SUMMARY OF THE INVENTION

According to the present invention, there is provided a semiconductor memory as claimed in claim 1.

Thus, the present invention may provide a nonvolatile semiconductor memory that is partially rewritable and inexpensive in construction. The present invention may combine a large-capacity mask ROM with a small-capacity PROM between which selection is made for use as required.

The mask ROM uses in the invention has a prescribed capacity that is large enough for the designed purpose, and data may be written in the mask ROM during manufacture of the memory. On the other hand, the PROM in the preferred embodiment has a capacity sufficiently smaller than that of the mask ROM.

An address storage circuit is formed from a nonvolatile semiconductor memory such as an EPROM and is capable of storing modified addresses by associating them with the addresses on the PROM. The modified addresses designate the data portions that were identified as differing from the original data stored in the mask ROM when modified data was compared with the data stored in the mask ROM. When the data stored in the mask ROM needs modification, the data is sequentially read out of the mask ROM for one-on-one comparison with the modified data, and only when a mismatch is found in the data, the modified data is written into the PROM, while the address of the modified data is stored as a modified address in the address storage circuit by associating it with the address on the PROM at which the modified data is written. Rewriting data can be done as many times as required by erasing the memory contents of the address storage circuit and the PROM. Associating the modified address with the address on the PROM can be easily accomplished by, for example, matching the address on the address storage at which the modified address is stored with the address on the PROM at which the modified data is stored.

An address match detection means is used to determine if the accessed address matches any of the modified addresses stored in the address storage circuit. When the address match detection means has detected the address match between them, the output data selector outputs the data that is read from the PROM at the address associated with the modified address. Therefore, in this case, the wrong or old data stored in the mask ROM is prevented from being output, and only the modified data is output. On the other hand, when no address match exists, the output data selector outputs the data that is read from the mask ROM at the accessed address. Therefore, in this case, the original data remaining intact by the modification is output from the mask ROM. If no data modification has been done and therefore there is no modified address stored in the address storage, the data stored in the mask ROM is directly output at all times since no address match is detected by the address match detection means.

Thus, rewriting data is possible as much as the memory capacity of the PROM allows, and the modified data can be output in a reliable manner despite the original data being stored in the mask ROM. Furthermore, by making the memory capacity of the PROM sufficiently smaller than that of the mask ROM, the cost increase from a single mask ROM construction can be minimized.

The following description and the annexed drawings set forth in detail certain illustrative embodiments of the invention. These embodiments are indicative, however, of but only a few of the various ways in which the principles of the invention may be employed. Other advantages and novel features of the invention will become apparent from the following detailed description of the invention when considered in conjunction with the drawings.

## BRIEF DESCRIPTION OF THE DRAWINGS

This invention may be better understood and its numerous advantages will become apparent to those skilled in the art by reference to the accompanying drawings as follows:

Figure **1** is a block diagram of a semiconductor memory in accordance with one embodiment of the present invention;

Figure **2** is a flowchart illustrating a data rewrite operation in the semiconductor memory of Figure **1** in accordance with the present invention;

Figure **3** is a timing chart showing the state of each signal at the time of rewriting data in the semiconductor memory in accordance with the present invention;

Figure **4** is a flowchart illustrating an operation of data write to a PROM in the semiconductor memory in accordance with the present invention; and

Figure **5** is a flowchart illustrating the operation of data read from the semiconductor memory in accordance with the present invention.

## DESCRIPTION OF THE PREFERRED EMBODIMENTS

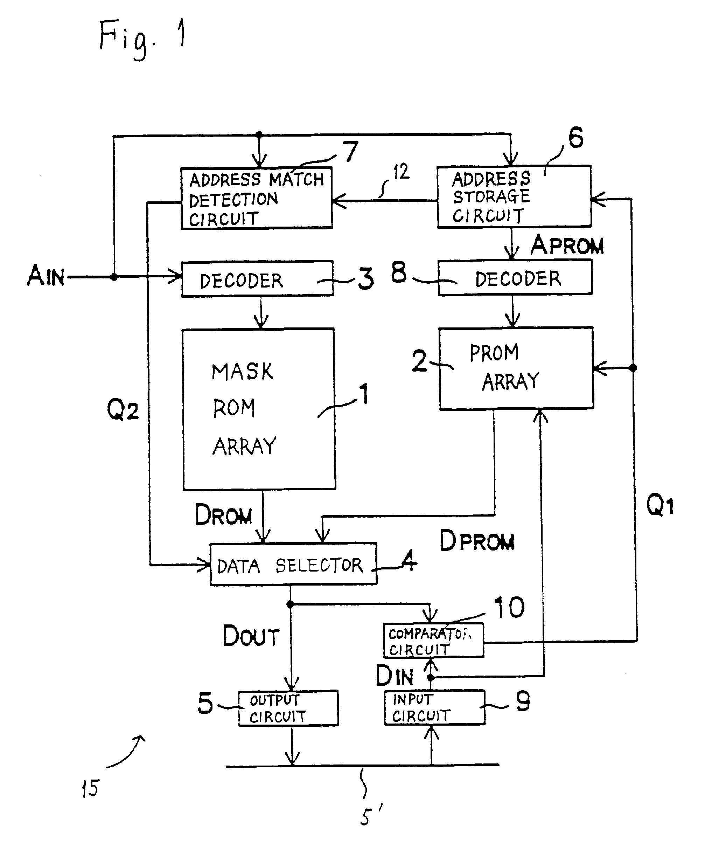

Referring now to the drawings where like reference numerals are used to refer to like elements throughout, the semiconductor memory **15** of the present embodiment is a partially rewritable read-only memory including, as shown in Figure **1**, a mask ROM array **1** and a PROM array **2**. Preferably, the mask ROM array **1** is a large-capacity nonvolatile semiconductor memory array in which the stored data are written during manufacture of the memory. The PROM array **2**, on the other hand, preferably has a relatively small memory capacity.

An external input address $A_{IN}$ transferred through a plurality of address lines is input to the mask ROM array **1** via a decoder **3**, to an address storage circuit **6**, and to an address match detection circuit **7**. When the input address $A_{IN}$ is given, the addressed data $D_{ROM}$ is read from the mask ROM array **1** and is transferred via a data selector **4** and an output circuit **5** onto an external data bus **5'**.

The PROM array **2** is a nonvolatile EPROM memory array in which data can be written electrically. An address $A_{PROM}$ which is output from the address storage circuit **6** is given to the PROM array **2** via a decoder **8**. When the address $A_{PROM}$ is given, modified data $D_{PROM}$ is read from the PROM array **2** and is transferred via the data selector **4** and the output circuit **5** onto the external data bus **5'**. The decoders **3** and **8** are provided to perform row decoding of addresses, etc. within the semiconductor memory. The output circuit **5** is an interface circuit that interfaces with the external data bus **5'**.

The address storage circuit **6** is formed from a nonvolatile EPROM that stores modified addresses equivalent to the memory capacity of the PROM array **2**, and is capable of outputting the stored modified addresses sequentially to the address match detection circuit 7 via line 12. The address match detection circuit 7 is a circuit which, when the input address $A_{IN}$ is given, compares the input address $A_{IN}$ with each modified address sent from the address storage circuit 6, and when the addresses match, issues an active select signal $Q_2$ to the data selector 4.

In addition, when an address match is detected by the address match detection circuit 7, the address storage circuit 6 outputs the address at which the modified address is stored, to deliver it as the address $A_{PROM}$ to the PROM array 2 via the decoder 8. The data selector 4 is a multiplexer that selects the modified data $D_{PROM}$ read from the PROM array 2 to be output as output data $D_{OUT}$ when the select signal $Q_2$ from the address match detection circuit 7 is set active, and selects the data $D_{ROM}$ read from the mask ROM array 1 to be output as output data $D_{OUT}$ when the select signal $Q_2$ is inactive. The input address $A_{IN}$ is also given to the address storage circuit 6 so that modified data can be input at the time of rewriting data as is described in detail below.

The semiconductor memory 15 of the present embodiment is also provided with an input circuit 9 for inputting new data when rewriting data. The input circuit 9 is an interface circuit that interfaces with the external data bus 5', and the input data $D_{IN}$ transferred through the input circuit 9 from the external data bus 5' is fed to a comparator circuit 10 and to the PROM array 2. Besides the input data $D_{IN}$, the output data $D_{OUT}$ from the data selector 4 is also fed to the comparator circuit 10 so that the input data $D_{IN}$ and the output data $D_{OUT}$ are compared. When these data do not match, the comparator circuit 10 issues an active mismatch signal $Q_1$ to the address storage circuit 6 and the PROM array 2, causing them to store the input address $A_{IN}$ and the input data $D_{IN}$, respectively.

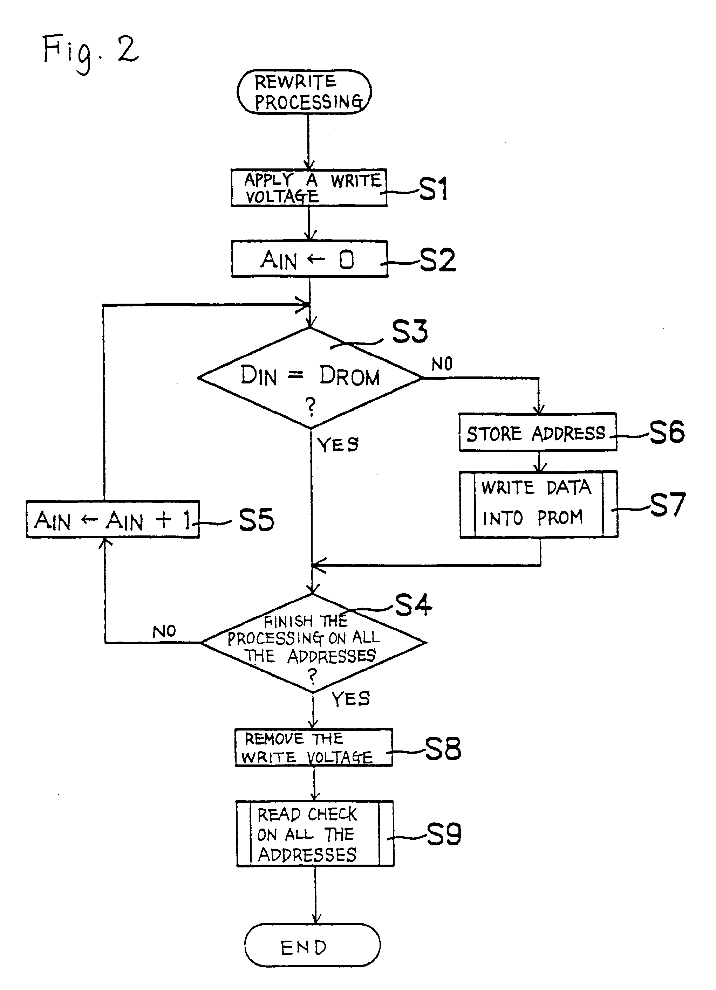

The operation of the thus constructed semiconductor memory 15 will now be described with reference to Figures 2 to 5.

Suppose an error is discovered in the data stored in the mask ROM array 1 of the semiconductor memory 15, making it necessary to rewrite or modify the stored data. First, in step S1 shown in Figure 2, a high write voltage is applied to a write power supply terminal $V_{pp}$ (not shown) on the PROM array 2, and then (in step S2), the lowest address 0 is set as the input address $A_{IN}$, and at the same time, modified data corresponding to the address 0 is transferred onto the external data bus 5'. Using the input address $A_{IN}$, data $D_{ROM}$ is read from the mask ROM array 1. Since no modified addresses are stored in the address storage circuit 6 yet in this particular example, the data selector 4 outputs the data $D_{ROM}$ as output data $D_{OUT}$.

Next, the comparator circuit 10 compares the data $D_{ROM}$, which is read from the mask ROM array 1 at the address corresponding to the input address $A_{IN}$, with the input data $D_{IN}$ supplied through the input circuit 9 (step S3). If these data match, then it is checked if the processing has been done on all the addresses of the semiconductor memory (step S4), and if not yet, the process returns to step S3 after incrementing the input address $A_{IN}$ (step S5), the process being repeated thereafter as long as a data match exists.

On the other hand, if, in step S3, the output data $D_{OUT}$ read from the mask ROM array 1 does not match the input data $D_{IN}$ which is the modified data, the input address $A_{IN}$ is stored as a modified address in the address storage circuit 6 (step S6), and at the same time, the input data $D_{IN}$ is written as modified data into the PROM array 2 (step S7). At this time, the address storage circuit 6 sends the address $A_{PROM}$, at which the modified address is stored, to the PROM array 2 via the decoder 8 so that the input data $D_{IN}$ is written at the equivalent address. Therefore, the modified address stored in the address storage circuit 6 and the modified data stored in the PROM array 2 are related to each other in that the modified data is stored in the PROM array 2 at the same address at which the modified address is stored in the address storage circuit 6.

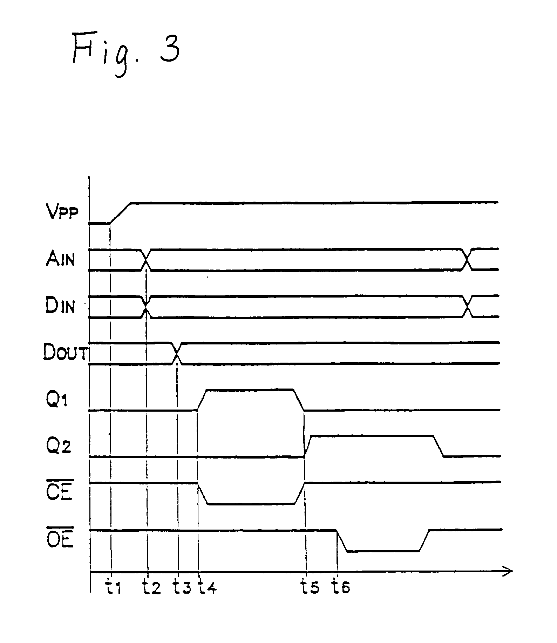

The sequence of operation that leads to the writing of the input data $D_{IN}$ into the PROM array 2 (step S7) will be described below with reference to the timing chart of Figure 3.

First, by the processing in step S1 referred to in Figure 2, a high write voltage is applied to the write power supply terminal $V_{pp}$ at time $t_1$, to ready the PROM array 2 for data write. Next, at time $t_2$, the input address $A_{IN}$ and the input data $D_{IN}$ are entered to the semiconductor memory 15. After a short delay, at time $t_3$, the output data $D_{OUT}$ becomes valid and is compared with the input data $D_{IN}$. If a mismatch is detected between these two data, the mismatch signal $Q_1$ is set active at time $t_4$, which causes the address storage circuit 6 to store the input address $A_{IN}$ as a modified address, while, at the same time, the chip enable signal $\overline{CE}$ is set active (i.e., goes "low"), causing the PROM array 2 to store the input data $D_{IN}$ as modified data at the address $A_{PROM}$ given from the address storage circuit 6.

When the modified address is stored in the address storage circuit 6, an address match with the input address $A_{IN}$ is detected and the select signal $Q_2$ is set active at time $t_5$. As a result, the data selector 4 is caused to switch to the PROM array 2 side and, at time $t_6$, the out enable signal $\overline{OE}$ is set active, thus reading the just stored modified data $D_{PROM}$ from the PROM array 2. The modified data $D_{PROM}$ is supplied as output data $D_{OUT}$ to the comparator circuit 10 where it is compared with the input data $D_{IN}$. When these data match and thus the write proves to be successful, the processing in step S7 is completed.

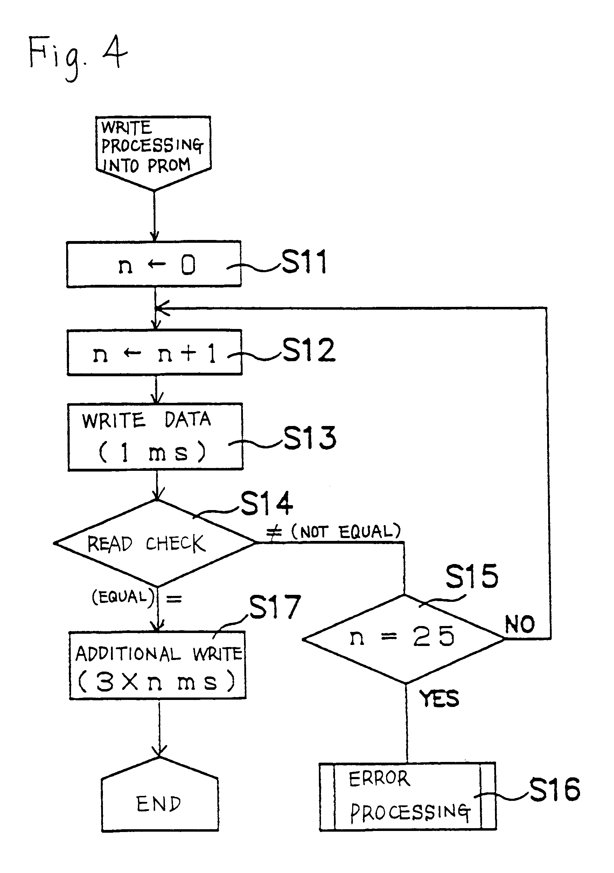

The above description has dealt with the case in which the data has been written successfully to the PROM array 2 at the first attempt. However, because of variations in the write characteristics of EPROM, the write time will become long with a resultant decrease in productivity if reliable data write is to be ensured at the first attempt. Therefore, the actual write operation to the PROM preferably is performed in the procedure shown in Figure 4. First, the counter n is set to 0 (step S11), and after incrementing the value of the counter n by 1 (step S12), data write is performed for 1 ms (step S13). Next, read check is performed to verify the written data (step S14), and if the data write has not been successful, the loop starting from step S12 is repeated until the value of the counter n reaches 25 (step S15). If successful data write has not been attained until the value of the counter n has reached 25, the process is suspended and appropriate error processing is performed (step S16). If it is determined in the read check in step S14 that the write has been made successfully, the current value of the counter n that represents the number of writes so far tried is tripled, and additional write is performed for a duration of time equal to ((3 x n) ms) (step S17), then terminating the process normally. Thus, the average write time is reduced as compared with the case in which data write is performed only once.

When the write to the PROM array **2** is completed as described above, the process proceeds from step S7 to step S4 in which it is checked if the processing has been performed on all the addresses. If not yet, the processing of steps S6 and S7 is repeated each time a mismatch occurs between input data $D_{IN}$ and data $D_{ROM}$. When the processing has been completed on all the addresses, the write voltage applied to the write power supply terminal $V_{pp}$ is removed (step S8), and after read check is performed on all the addresses (step S9), the data rewrite process is completed.

As described, in the semiconductor memory of the present embodiment, the modified data is compared with the original data stored in the mask ROM array **1** and only portions of data that differ from the original are stored in the PROM array **2**, thus achieving partial rewriting of data.

In the present embodiment, the comparison check in step S3 of the above data rewrite process is performed using the comparator circuit **10** internal to the semiconductor memory, and the chip enable signals $\overline{CE}$, etc. are controlled externally by monitoring the state of the mismatch signal $Q_1$. However, all such processing may be performed by internal hardware of the semiconductor memory, or alternatively, the processing including the comparison check by the comparator circuit **10** may be performed using an external operation program.

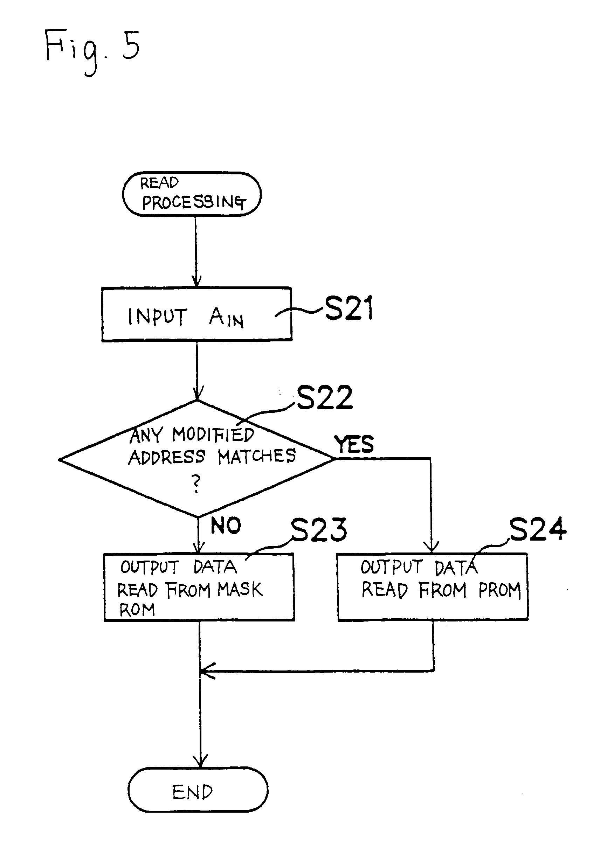

An operation of data read from the thus rewritten semiconductor memory will now be described with reference to the flowchart of Figure 5. The same read operation is also performed in the read check in step S9 in Figure 2.

First, the input address $A_{IN}$ accessed by the system is input (step S21), and the address match detection circuit **7** checks if any modified address that matches the accessed address is stored in the address storage circuit **6** (step S22). If there is no address match, since the select signal $Q_2$ remains inactive, the data $D_{ROM}$ read from the mask ROM array **1** is output as output data $D_{OUT}$ (step S23). Therefore, the data originally stored in the mask ROM array **1** is directly output for the portions of data that have not been modified.

On the other hand, if an address match is detected by the address match detection circuit **7** in step S22, the address $A_{PROM}$ on the address storage circuit **6** at which the modified address is stored is transferred to the PROM array **2** to read modified data $D_{PROM}$ from the corresponding address. The modified address stored in the address storage circuit **6** represents the input address $A_{IN}$ which was input when a mismatch was detected between the data $D_{ROM}$ stored in the mask ROM array 1 and the input data $D_{IN}$ during the previous data rewrite process, and the modified data $D_{PROM}$ read from the PROM array **2** corresponds to the input data $D_{IN}$ that was input at that time. When the address match is detected, the address match detection circuit **7** sets the select signal $Q_2$ active, which causes the data selector **4** to switch to the PROM array **2** side. As a result, the original data $D_{ROM}$ read from the mask ROM array 1 is blocked by the data selector **4**, allowing the modified data $D_{PROM}$ read from the PROM array **2** to be output as the output data $D_{OUT}$ (step S24).

Thus, according to the semiconductor memory of the present embodiment, the data read from the mask ROM array **1** is directly output for the portions of data that were not the objects of modification at the time of rewriting data, while for the portions that were modified, the data read from the PROM array **2** is output, thus making it possible to essentially rewrite part of the stored data within the memory capacity of the PROM array **2** despite the construction being a read-only memory consisting primarily of an inexpensive mask ROM.

In the present embodiment, since the addresses of the semiconductor memory are random-accessed, it is necessary for the address match detection circuit **7** to compare the input address $A_{IN}$ with each modified address sequentially given from the address storage circuit **6** (though it is possible to speed up the detection process by such processing as determining that no address match exists when the modified address being given sequentially becomes higher than the input address $A_{IN}$). However, in cases where the data stored in the semiconductor memory is always accessed sequentially, it may be so configured that the address match detection circuit **7** first reads out the top modified address from the address storage circuit **6** and increments the modified address each time it matches the input address $A_{IN}$, thus requiring comparison with only one modified address each time.

As is apparent from the above description, according to the semiconductor memory of the present invention, since the output data selector 4 automatically reads data from the PROM and outputs the thus readout data only for modified portions despite the original data being stored in the mask ROM, it is possible to essentially rewrite the stored data within the memory capacity of the PROM. Furthermore, by making the memory capacity of the PROM sufficiently smaller than that of the mask ROM, the cost increase from a single mask ROM construction can be minimized. It will be appreciated that only those data stored in the mask ROM array 1 which contain errors need be rewritten to the PROM array 2, thus reducing the required memory capacity of the PROM 2. Also, since an ordinary write algorithm can be used to rewrite the mask ROM, partially rewriting the mask ROM data can be achieved in a short time.

It is understood that various other modifications will be apparent to and can be readily made by those skilled in the art without departing from the scope of this invention. Accordingly, it is not intended that the scope of the claims appended hereto be limited to the specific embodiments described herein.

**Claims**

1. A semiconductor memory comprising:

    a read-only memory (ROM) (1) having original data ($D_{ROM}$) stored therein;

    a programmable read-only memory (PROM) (2) for storing substitute data ($D_{PROM}$) to replace a portion of said original data;

    address storage means (6) for storing one or more addresses which correspond to one or more addresses in said ROM which contain said portion of original data to be replaced;

    address comparison means (7) for comparing an accessed address ($A_{IN}$) with at least one of said stored addresses and, based on said comparison, providing either a first or second comparison response ($Q_2$); and

    output data selector means (4) for outputting said substitute data read from said PROM and corresponding to one of the stored addresses when said first comparison response is detected, and for outputting said original data read from said ROM at said accessed address when said second comparison response is detected, characterised by comparator means (10) for comparing input data ($D_{IN}$) to said original data read from said ROM, automatically storing portions of the input data which differ from said original data as said substitute data in said PROM, and automatically storing the addresses of the original data which differ from the input data in the address storage means.

2. A semiconductor memory as claimed in claim 1, characterized in that said addresses are stored in said address storage means (6) at addresses which correspond respectively to the addresses ($A_{PROM}$) in said PROM at which said substitute data are stored.

3. A semiconductor memory according to claim 1 or claim 2, wherein said first comparison response is provided when said accessed address ($A_{IN}$) and one of said stored addresses match, and said second comparison response is provided when said accessed address does not match said stored addresses.

4. A semiconductor memory according to any one of claims 1 to 3 wherein the memory capacity of said PROM (2) is smaller than the memory capacity of said ROM (1).

5. A semiconductor memory according to any preceding claim, wherein said ROM (1) comprises a mask ROM.

6. A semiconductor memory according to any preceding claim, wherein said PROM (2) comprises an erasable PROM (EPROM).

7. A semiconductor memory according to any one of claims 1 to 5 wherein said PROM (2) comprises an electrically erasable PROM (EEPROM).

**Patentansprüche**

1. Halbleiterspeicher mit:

    - einem Festwertspeicher (ROM) (1) mit darin abgespeicherten ursprünglichen Daten ($D_{ROM}$);

    - einem programmierbaren Festwertspeicher (PROM) (2) zum Abspeichern von Ersetzungsdaten ($D_{PROM}$) zum Ersetzen eines Teils der ursprünglichen Daten;

    - einer Adressenspeichereinrichtung (6) zum Abspeichern einer oder mehrerer Adressen, die einer oder mehreren Adressen im ROM entsprechen, die den Teil der zu ersetzenden ursprünglichen Daten enthalten;

    - einer Adressenvergleichseinrichtung (7) zum Vergleichen einer Zugriffsadresse ($A_{EIN}$) mit mindestens einer der abgespeicherten Adressen und zum Ausgeben, auf Grundlage des Vergleichs, entweder einer ersten oder einer zweiten Vergleichsantwort ($Q_2$); und

- einer Ausgangsdatenselektoreinrichtung (4) zum Ausgeben des aus dem PROM ausgelesenen Ersetzungsdatenwerts, der einer der abgespeicherten Adressen entspricht, wenn die erste Vergleichsantwort erkannt wird, und zum Ausgeben des aus dem ROM unter der Zugriffsadresse ausgelesenen ursprünglichen Datenwerts, wenn die zweite Vergleichsantwort erkannt wird; **gekennzeichnet durch** eine Komparatoreinrichtung (10) zum Vergleichen eines Eingangsdatenwerts ($D_{EIN}$) mit dem aus dem ROM ausgelesenen ursprünglichen Datenwert, zum automatischen Einspeichern von Teilen der Eingangsdaten, die sich von den ursprünglichen Daten unterscheiden, als Ersetzungsdaten im PROM, und zum automatischen Abspeichern der Adressen der ursprünglichen Daten, die sich von den Eingangsdaten unterscheiden, in der Adressenspeichereinrichtung.

2. Halbleiterspeicher nach Anspruch 1, **dadurch gekennzeichnet**, daß die Adressen in der Adressenspeichereinrichtung (6) an Adressen abgespeichert werden, die jeweils den Adressen ($A_{PROM}$) im PROM entsprechen, unter dem die Ersetzungsdaten abgespeichert sind.

3. Halbleiterspeicher nach Anspruch 1 oder Anspruch 2, bei dem die erste Vergleichsantwort geliefert wird, wenn die Zugriffsadresse ($A_{EIN}$) und eine der abgespeicherten Adressen übereinstimmen, und die zweite Vergleichsantwort geliefert wird, wenn die Zugriffsadresse nicht mit den abgespeicherten Adressen übereinstimmt.

4. Halbleiterspeicher nach einem der Ansprüche 1 bis 3, bei dem die Speicherkapazität des PROMs (2) kleiner als die Speicherkapazität des ROMs (1) ist.

5. Halbleiterspeicher nach einem der vorstehenden Ansprüche, bei dem der ROM (1) einen Masken-ROM aufweist.

6. Halbleiterspeicher nach einem der vorstehenden Ansprüche, bei dem der PROM (2) einen löschbaren PROM (EPROM) aufweist.

7. Halbleiterspeicher nach einem der Ansprüche 1 bis 5, bei dem der PROM (2) einen elektrisch löschbaren PROM (EEPROM) aufweist.

**Revendications**

1. Mémoire à semi-conducteurs comprenant:

une mémoire morte (ROM) (1) ayant des données originales ($D_{ROM}$) mémorisées à l'intérieur;

une mémoire morte programmable (PROM) (2) pour mémoriser des données de substitution ($D_{PROM}$) afin de remplacer une partie desdites données originales;

des moyens de stockage d'adresses (6) pour mémoriser une ou plusieurs adresses qui correspondent à une ou plusieurs adresses dans ladite mémoire ROM qui contient ladite partie à remplacer des données originales;

des moyens de comparaison d'adresses (7) pour comparer une adresse à laquelle il a été accédée ($A_{IN}$) avec au moins l'une desdites adresses mémorisées et, en fonction de ladite comparaison, pour fournir soit une première soit une seconde réponse de comparaison ($Q_2$); et

des moyens à sélecteur de données de sortie (4) pour délivrer lesdites données de substitution lues dans ladite mémoire PROM et correspondant à l'une des adresses mémorisées lorsque ladite première réponse de comparaison est détectée, et pour délivrer lesdites données originales lues dans ladite mémoire ROM à ladite adresse à laquelle il a été accédée lorsque ladite seconde réponse de comparaison est détectée, caractérisé par des moyens à comparateur (10) pour comparer des données d'entrée ($D_{IN}$) auxdites données originales lues dans ladite mémoire ROM, pour mémoriser de manière automatique des parties des données d'entrée qui diffèrent desdites données originales en tant que lesdites données de substitution dans ladite mémoire PROM, et pour mémoriser de manière automatique les adresses des données originales qui diffèrent des données d'entrée dans les moyens de stockage d'adresses.

2. Mémoire à semi-conducteurs selon la revendication 1, caractérisée en ce que lesdites adresses sont mémorisées dans lesdits moyens de stockage d'adresses (6) à des adresses qui correspondent respectivement aux adresses ($A_{PROM}$) dans ladite mémoire PROM auxquelles lesdites données de substitution sont mémorisées.

3. Mémoire à semi-conducteurs selon la revendication 1 ou 2, dans laquelle ladite première réponse de comparaison est fournie lorsque ladite adresse à laquelle il a été accédée ($A_{IN}$) et l'une desdites adresses mémorisées coïncident, et ladite seconde réponse de comparaison est fournie lorsque ladite adresse à laquelle il a été accédée ne coïncide pas avec lesdites adresses mémorisées.

4. Mémoire à semi-conducteurs selon l'une quelconque des revendications 1 à 3, dans laquelle la capacité mémoire de ladite mémoire PROM (2) est plus petite que la capacité mémoire de ladite mémoire ROM (1).

5. Mémoire à semi-conducteurs selon l'une quelconque des revendications précédentes, dans laquelle ladite mémoire ROM (1) comprend une mémoire ROM programmée par masquage.

6. Mémoire à semi-conducteurs selon l'une quelconque des revendications précédentes, dans laquelle ladite mémoire PROM (2) comprend une mémoire effaçable PROM (EPROM).

7. Mémoire à semi-conducteurs selon l'une quelconque des revendications 1 à 5, dans laquelle ladite mémoire PROM (2) comprend une mémoire PROM effaçable de manière électrique (EEPROM).

Fig. 1

Fig. 2

REWRITE
PROCESSING

APPLY A WRITE
VOLTAGE — S1

AIN ← 0 — S2

DIN = DROM
? — S3

NO

STORE ADDRESS — S6

WRITE DATA
INTO PROM — S7

YES

AIN ← AIN + 1 — S5

FINISH THE
PROCESSING ON ALL
THE ADDRESSES
? — S4

NO

YES

REMOVE THE
WRITE VOLTAGE — S8

READ CHECK
ON ALL THE
ADDRESSES — S9

END

# Fig. 3

Fig. 4

Fig. 5